# EUROPEAN PATENT APPLICATION

(11) **EP 1 295 635 A1**
(43) Date of publication of application: **26.03.2003**
(21) Application number: 02255998.3
(22) Date of filing: 29.08.2002
(51) Int. Cl.: B01J 19/00

(54) **Pin plate for use in array printing and method for making the pin plate**

(30) Priority: 24.09.2001 US 962831
(71) Applicant: Corning Incorporated, Corning, New York 14831 (US)
(72) Inventor: Brady, Michael Donovan, Painted Post, NY 14870 (US); Guermeur, Celine Claude, 77590 Chartrettes (FR); Custer, Martha Blanche, Painted Post, NY 14870 (US); Paterson, Richard Curwood, Elmira Heights, NY 14903 (US); Share, Christine Marie, Macedon, NY 14502 (US)
(74) Representative: Marchant, James Ian

(57) **Abstract**

A pin plate used to print a high density array printing of materials such as biological inks and a method for manufacturing the pin plate are described herein. The pin plate can be manufactured by coating a top surface of a silica wafer with a substantially thick layer of photoresist material. Next, a photolithography process is used to remove selected areas of the photoresist material from the silica wafer. Thereafter, a reactive ion etching process is used to form the pins in the silica wafer by etching away a predetermined amount of the top surface from the silica wafer that is not covered by the photoresist material. Afterwards, the remaining photoresist material is removed from the silica wafer which now resembles the pin plate.

## Description

### Background of the Invention

### Field of the Invention

The present invention relates to a pin plate and a method for manufacturing the pin plate which is used to print a high-density array of material such as biological inks.

### Description of Related Art

A pin plate (printing plate) is a device which is used to print a high density array of material onto a printing sheet. Basically to print a high density array of material, pins on the pin plate are aligned over and then lowered into the material which is often a liquid biological ink held in a series of capillaries in a reservoir structure. After the pins have made contact with the material, the pins are withdrawn and a portion of the material in each of the capillaries remains on an end of each of the pins. Next, the pin plate is positioned over and then lowered down towards the printing sheet until the material on the ends of the pins contacts the printing sheet. After the material on each pin has contacted the printing sheet, the pin plate is moved away from the printing sheet. As the pins are moved away from the printing sheet at least a portion of the material remains on the printing sheet. This is a typical process for printing a high density array of material such as biological inks.

To date a variety of different processes have been used to manufacture pin plates. Examples of two traditional manufacturing processes are briefly described below. In the first example of a known manufacturing process, a pin plate has been made by using a photomask to enable ultraviolet light to expose selected areas of a photosensitive glass (e.g., FOTOFORM^{TM} made by Corning Inc.). The exposed selected areas of the photosensitive glass are etched with hydrofluoric acid to form the pin plate. The pin plate is then heated at a high temperature which causes some shrinkage and loss of resolution. Thereafter, the top surfaces of the pins on the pin plate are hand polished to obtain a reasonable planarity. This pin plate while profitable is difficult make and even more difficult to reproduce with a relatively high yield in that the current yield is often ten percent or less.

In the second example of a known manufacturing process, a pin plate has been made by making a master pin plate image in a photoresist material, casting a silicone replica of the master pin plate image in the photoresist material, making a curable epoxy cast of the silicone replica and finally depositing a silica coating onto the epoxy image to create the pin plate. Like the first example, this manufacturing process makes it difficult for a manufacturer to reproduce pin plates with a relatively high yield and also requires a level of sophistication that makes it hard to use in a manufacturing environment. Accordingly, there is and has been a need for a method of manufacturing a pin plate that is highly controllable, reproducible and relatively inexpensive. These needs and other needs are satisfied by the pin plate and the method of the present invention.

### BRIEF DESCRIPTION OF the Invention

The present invention includes a pin plate which is used to print a high density array printing of materials such as biological inks and a method for manufacturing the pin plate. The pin plate can be manufactured by coating a top surface of a silica wafer with a substantially thick layer of photoresist material. Next, a photolithography process is used to remove selected areas of the photoresist material from the silica wafer. Thereafter, a reactive ion etching process is used to form the pins in the silica wafer by etching away a predetermined amount of the top surface from the silica wafer that is not covered by the photoresist material. Afterwards, the remaining photoresist material is removed from the silica wafer which now resembles the pin plate.

### Brief Description of the Drawings

A more complete understanding of the present invention may be had by reference to the following detailed description when taken in conjunction with the accompanying drawings wherein:

FIGURE 1 is a partial perspective view of an exemplary pin plate in accordance with the present invention;

FIGURE 2 is a flowchart illustrating the steps of a preferred method for making the pin plate shown in FIGURE 1;

FIGURES 3a-3f are cross-sectional side views of the pin plate at different steps in the method shown in FIGURE 2;

FIGURES 4a-4d are partial perspective views of pins in a pin plate that was made using Plasmatherm's reactive ion etching process with inductively coupled plasma;

FIGURES 5a-5b are partial perspective views of pins in a pin plate that was made using Surface Technology System's multiplex reactive ion etching process with inductively coupled plasma;

FIGURES 6a-6b are partial perspective views of pins in a pin plate that was made using IBM's reactive ion etching process without inductively coupled plasma; and

FIGURE 7 is a partial perspective view of pins in a pin plate that was made using Nextral's NE500 reactive ion etching process without inductively coupled plasma.

### DETAILED DESCRIPTION OF THE DRAWINGS

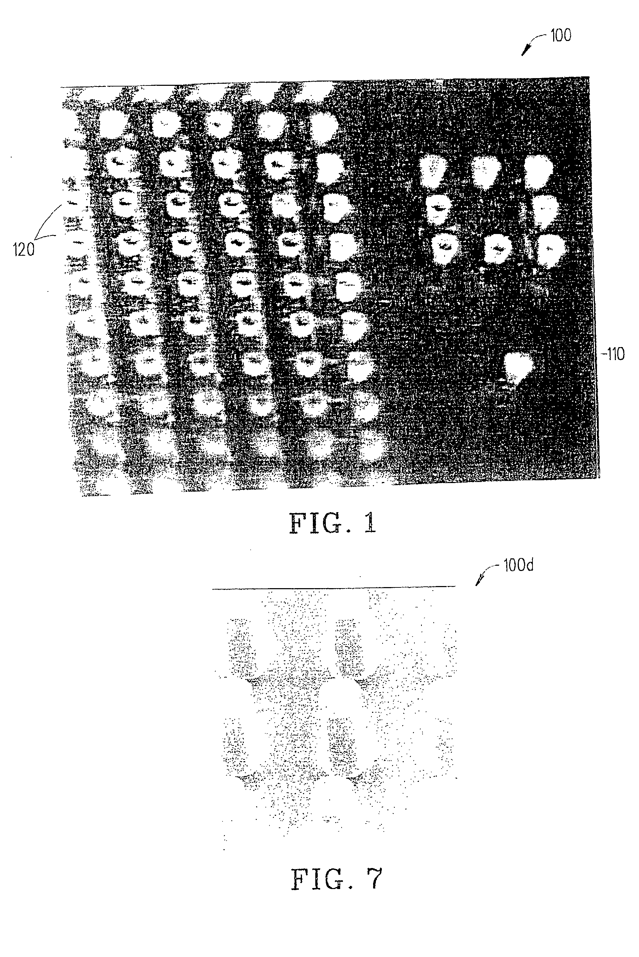

Referring to FIGURES 1-7, there are disclosed preferred embodiments of a pin plate 100 and a preferred method 200 for making the pin plate 100 in accordance with the present invention. The pin plate 100 is typically used to print a high density array of material such as biological inks. Although the pin plate 100 is not described below as being used in a particular application, it should be understood that the pin plate 100 could be used in a wide array of applications including genomic research, DNA sequencing, drug screening, drug research, proteomics or any other application involving biological molecule transfer. Accordingly, the pin plate 100 and method 200 should not be construed in such a limited manner.

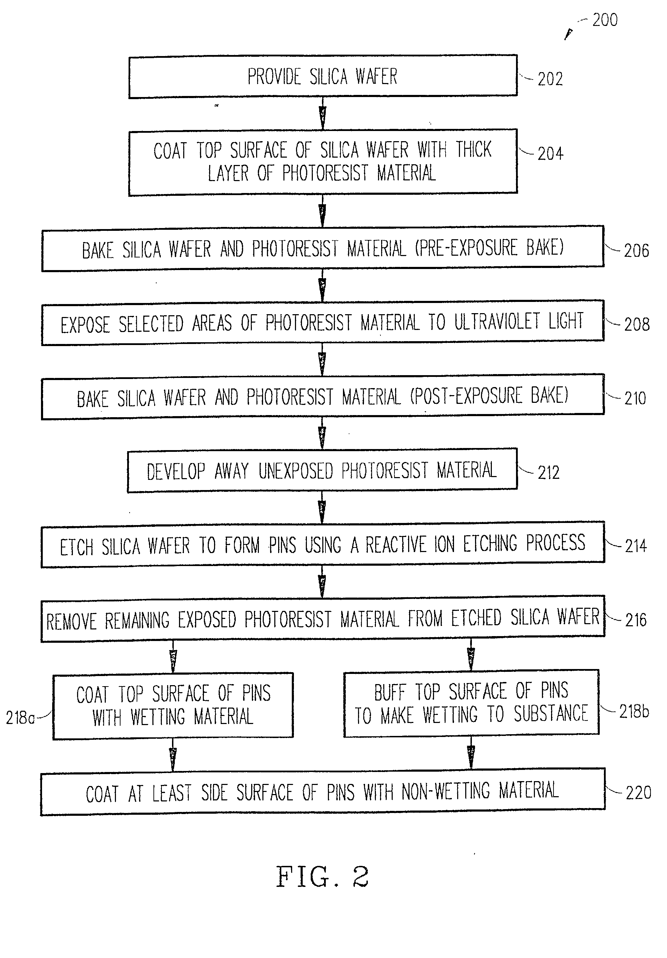

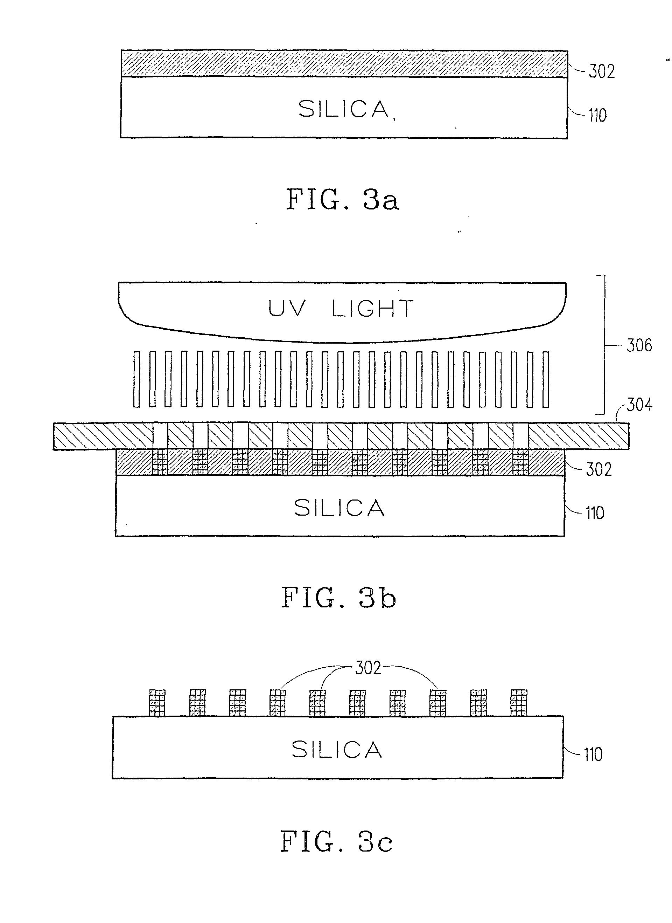

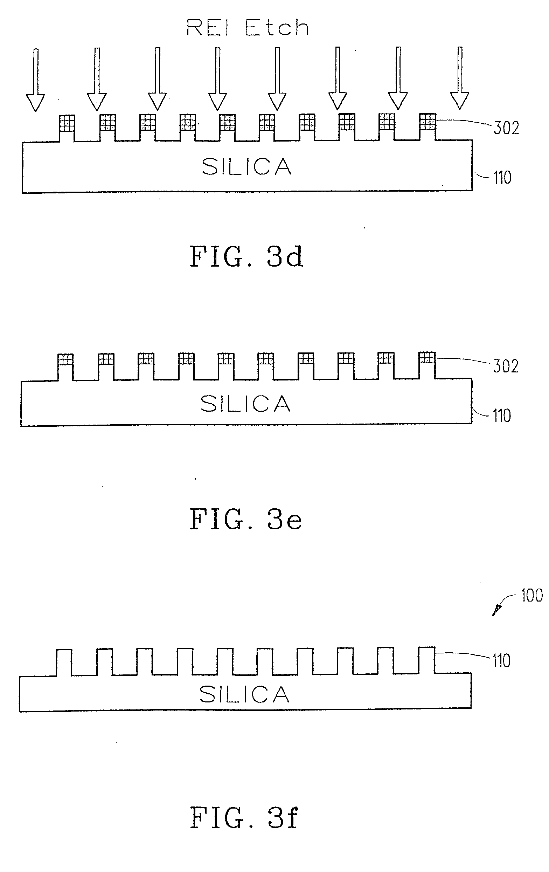

Referring to FIGURE 1, there is a partial perspective view of an exemplary pin plate 100 in accordance with the present invention. Basically, the pin plate 100 (e.g., printing plate) includes a substrate 110 (e.g., transparent substrate, silica substrate, polished silica wafer) that has a series of pins 120 extending away from a top surface of the substrate 110. The pins 120 are formed by using a reactive ion etching process which etches away a predetermined amount of the top surface from the substrate 110. In particular, the pin plate 100 can be manufactured by coating a top surface of a substrate 110 with a substantially thick layer of photoresist material. Next, a photolithography process is used to remove selected areas of the photoresist material from the substrate 110. Thereafter, a reactive ion etching process is used to form the pins 120 in the substrate 110 by etching away a predetermined amount of the top surface from the substrate 110 that is not covered by the photoresist material. Afterwards, the remaining photoresist material is removed from the substrate 110 which now resembles the pin plate 100. A more detailed description about how the pin plate 100 is manufactured and, in particular, how the pins 120 are etched out of the substrate 110 is provided below with respect to FIGURES 2 and 3.

Referring to Figures 2 and 3, there are respectively illustrated a flowchart of the preferred method 200 for making the pin plate 100 and various cross-sectional side views of the pin plate 100 at different steps in the preferred method 200. In the preferred embodiment of the pin plate 100, the substrate 110 is a polished silica wafer with a thickness of approximately 1.6 mm and the photoresist material is a negative-tone photoresist material with a thickness of approximately 200µm. The negative-tone photoresist material 302 can be SU-8 photoresist material that is currently manufactured and sold by MicroChem Corporation. However, it should be noted that other types of materials besides the silica wafer 110 and the SU-8 photoresist material 302 can be used in the present invention.

To manufacture the pin plate 100, the silica wafer 110 is provided (step 202) and coated (step 204) with a substantially thick layer of SU-8 photoresist material 302 (see FIGURE 3a). To coat a top surface of the silica wafer 110 with a desired thickness of SU-8 photoresist material 302, the SU-8 photoresist material 302 is spun onto the silica wafer 110 at a speed based on the viscosity of the SU-8 photoresist material 302.

The silica wafer 110 and, in particular, the SU-8 photoresist material 302 is then baked (step 206) to remove solvent from the SU-8 photoresist material 302. For instance, the SU-8 photoresist material 302 and the silica wafer 110 can undergo a pre-exposure bake at 95°C for around four hours to remove the solvent from the SU-8 photoresist material. To keep internal stresses to a minimum, an initial bake at 65-70°C for around 3 minutes can be performed prior to the pre-exposure bake.

Selected areas of the baked SU-8 photoresist material 302 that are not covered by a photomask 304 are then exposed (step 208) to ultraviolet light 306 (or similar light). Exposure to ultraviolet light 308 promotes cross-linking of the SU-8 photoresist material 302 not covered by the photomask 304 (see FIGURE 3b). For instance, the ultraviolet light 308 exposure dose can be approximately 800 mJ/cm² for a SU-8 photoresist material 302 that is 200µm thick. It should be understood that the shape of the pins 120 which can be, for example, round, square with rounded corners, square... is defined by the shape of the image made by the photomask 304.

After exposure to the ultraviolet light 306, the silica wafer 110 and the SU-8 photoresist material 302 are baked (step 210) to further polymerize the exposed SU-8 photoresist material 302. Typically, the SU-8 photoresist material 302 and the silica wafer 110 undergo a post-exposure bake on a hot plate at a temperature between 95°C and 200°C for approximately 15 minutes.

Upon completing the post-exposure bake, the unexposed SU-8 photoresist material 302 is developed (step 212) or removed from the silica wafer 110 (see FIGURE 3c). For instance, the unexposed SU-8 photoresist material 302 can be developed in a solvent such as PGMEA (propylene glycol methyl ether acetate). The unexposed SU-8 photoresist material 302 develop can be a three step process. First, an initial one-minute dip in PGMEA is performed. Second, a long dip is done in PGMEA for a time determined primarily by the thickness of the SU-8 photoresist material 302. Lastly as a rinse, a final dip in a fresh bath of PGMEA is used to rinse away any unexposed SU-8 photoresist material that remains on the silica wafer 110.

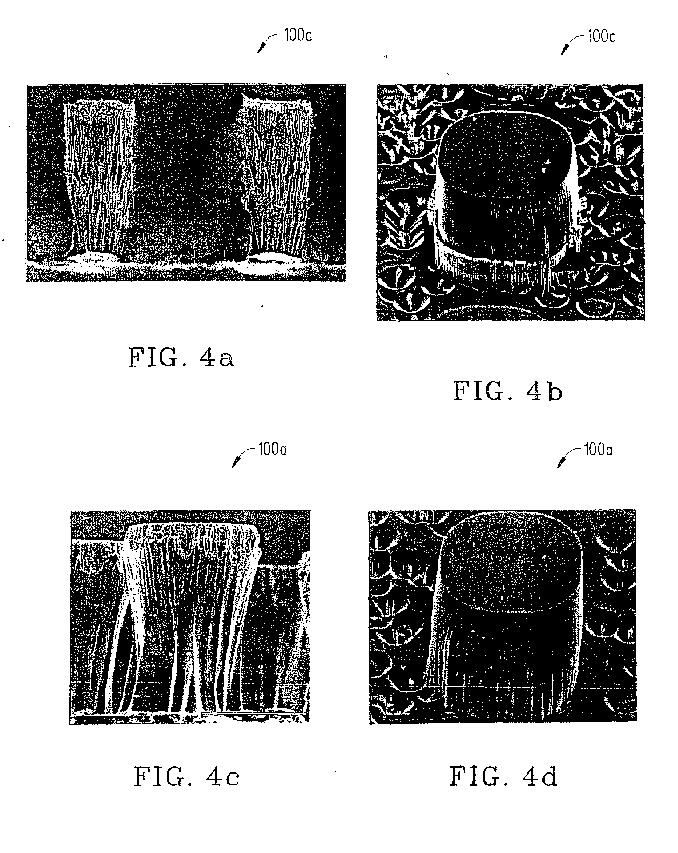

At this point in the manufacturing process, the silica wafer 110 and the polymerized SU-8 photoresist material 302 are subjected to a reactive ion etching (RIE) process (step 214). The RIE process effectively forms the pins 120 in the silica wafer 110 by etching away a predetermined amount of the top surface from the silica wafer 110 that is not covered by the exposed SU-8 photoresist material 302 (see FIGURE 3d). In particular, the RIE process can use a fluorocarbon etchant such as CHF₃ or C₄F₈. During the RIE process, it should be noted that a top layer of the exposed SU-8 photoresist material is also removed (see FIGURE 3e). Moreover, it should be noted that the RIE process used in the present invention can be performed with or without using inductively coupled plasma (see FIGURES 4-7). For more information about the RIE process reference is made to the following articles: (1) J.K. Bhardwaj et al. *"Advances in High Rate Silicon and Oxide Etching using ICP";* and (2) J.K. Bhardwaj et al. *"Advances in Deep Oxide Etch Processing for MEMS-Mask Selection".*

The remaining exposed SU-8 photoresist material 302 is then removed (step 216) from the silica wafer 110 which now resembles the pin plate 100 (see FIGURE 3f). A variety of substance such as CHF₃/O₂, PG remover, piranha or nitric acid can be used to remove the remaining exposed SU-8 photoresist material 302. Thereafter, the top surface of the pins 120 on the pin plate 100 (e.g., etched silica wafer 110) can be coated (step 218a) with a wetting material. Alternatively, the top surface of the pins 120 on the pin plate 100 (e.g., etched silica wafer 110) can be buffed (step 218b) to make the top surfaces wetting to a substance (e.g., biological ink) that is to be printed. It should be understood that the planarity of the top surfaces of the pins 120 which can be +/- 1µm is defined by the flatness of the silica wafer 100. Finally, the side surface of the pins 120 and the top surface of the pin plate 100 can be coated (step 220) with a non-wetting material including, for example, FDS or perfluorodecyltrichlorosilane.

The aforementioned preferred method 200 has been used to make pin plates 100 that have pins which are 100-150 microns in height, pin tops with widths of 100 microns and pin spacing of 220 microns on center. Due to the accuracy and reproducibility of the preferred method 200 it is believed that pin plates 100 can be manufactured which have pins that are 100 microns in height, pin tops with widths of 30 microns and pin spacing of 65 microns on center. However, it should be understood that the pin plate 100 can have any number of pins 120 and is not limited to any specific dimensions and configurations.

As mentioned above, the preferred type of photoresist material 302 is the negative-tone SU-8 photoresist material 302 which is manufactured and sold by MicroChem Corporation. However, it should be noted that a variety of photoresist materials now known or subsequently developed that have similar properties to SU-8 photoresist materials can be used in the present invention. As such, there is provided a detailed discussion about the physical and chemical characteristics of the SU-8 photoresist material 302.

Basically, the SU-8 photoresist material 302 is made of a multi-functional, highly branched polymeric epoxy resin dissolved in an organic solvent, along with a photoacid generator. The polymeric epoxy resin includes a bisphenol A novolac glycidyl ether; an "idealized" structure for the polymer is shown below: 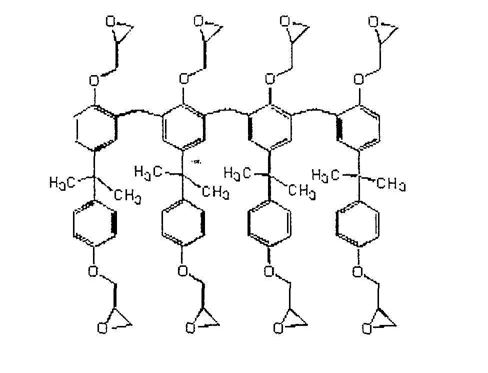 It should be understood that the polymer exist in a wide variety of sizes and shapes, but a typical polymer is as shown above. As can be seen, the typical polymer contains 8 epoxy groups, hence the "8" in SU-8.

The SU-8 photoresist material 302 also contains a photoacid generator (PAG) at a level of a few percent based on the mass of the epoxy resin. The PAG includes a triarylsulfonium salt. A photochemical transformation takes place upon absorption of a photon and the product is a strong acid. This reaction can be described by the equation below: 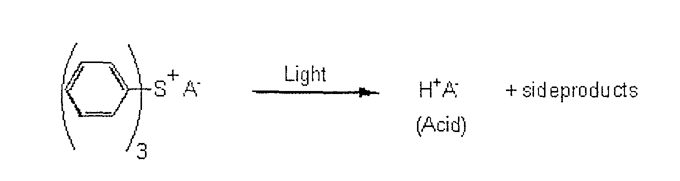 The strong acid or photoacid, designated H+A- in the equation above, is photochemically produced in the solid SU-8 photoresist material 302 upon absorption of ultraviolet light, and in particular only in the regions of the SU-8 photoresist material 302 that are directly exposed to the ultraviolet light. The photoacid acts as a catalyst in the subsequent crosslinking reaction that takes place during the post-exposure bake. In other words, the exposed SU-8 photoresist material 302 contains the acid catalyst, while the unexposed SU-8 photoresist material does not contain the acid catalyst.

A majority of the crosslinking reaction occurs during the post-exposure bake in the regions of the SU-8 photoresist material 302 that contain the acid catalyst. The post-exposure bake is necessary because the crosslinking reaction is very slow at ambient temperature, since the glass transition temperature (Tg) of the solid SU-8 photoresist material is about 55°C and very little reaction can take place in the solid state where molecular motion is effectively frozen. For a polymer, Tg is the temperature at which the transition between solid glass and viscous fluid occurs.

The crosslinking reaction which is catalyzed by the acid takes place in a "zipping up" fashion, where each epoxy group can react with another epoxy group, either in the same or different molecule. This crosslinking reaction does not occur in the absence of the acid. Extensive crosslinking yields a dense network, because as described above each epoxy is "pre-connected" to 7 others on the average. The crosslinking reaction can be described as below:

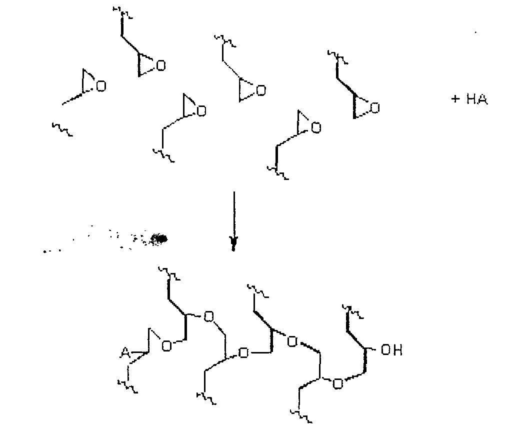

It should be noted that the post-exposure bake should be carried out at temperatures greater than Tg to be effective. Moreover, it should be noted that as crosslinking occurs the properties of the SU-8 photoresist material 302 change in several ways including: (1) some shrinking inevitably occurs due to reduction in free volume and increase in density; and (2) the Tg rises as the SU-8 photoresist material 302 becomes increasingly crosslinked, until the SU-8 photoresist material 302 becomes a solid. As crosslinking proceeds and the SU-8 photoresist material 302 gradually becomes more solid, the crosslinking reaction slows down and eventually stops. Thus, the final Tg of the SU-8 photoresist material 302 is dependent on the temperature of the post-exposure bake. After the post-exposure bake, the exposed, crosslinked SU-8 photoresist material 302 is insoluble in organic developers, while the unexposed, uncrosslinked SU-8 photoresist material 302 dissolves, thus forming a negative image of the mask (see FIGURE 3c). Subsequent to developing away the unexposed SU-8 photoresist material 302, the REI process is used to etch the silica wafer 110 and generate the pin plate 100 as describe above in detail with respect to FIGURES 2-3 and shown in detail below with respect to FIGURES 4-7.

Referring to FIGURES 4a-4d, there are illustrated different perspective views of pins in a pin plate 100a that was made using Plasmatherm's reactive ion etching process with inductively coupled plasma. In particular, FIGURES 4a and 4c show pins with descum and FIGURES 4b and 4d respectively show pins cleaned using a pyrolysis process and nitric acid. Plasmatherm's reactive ion etching process used to manufacture the illustrated pin plates 110a had the following properties:
- Etch plasma = CHF₃:Ar (42:3 sccm).
- 3" and 6" silica wafers were etched.
- Selectivity SiO₂:SU-8 photoresist material = 0.6:1 - 1:1.
- Etch rate = 5-15µm/hr (power dependent).
It should be noted that the use of ICP in a REI process enables faster etch rates (app. 2x) and increases ion directionality when compared to a REI process that does not use ICP.

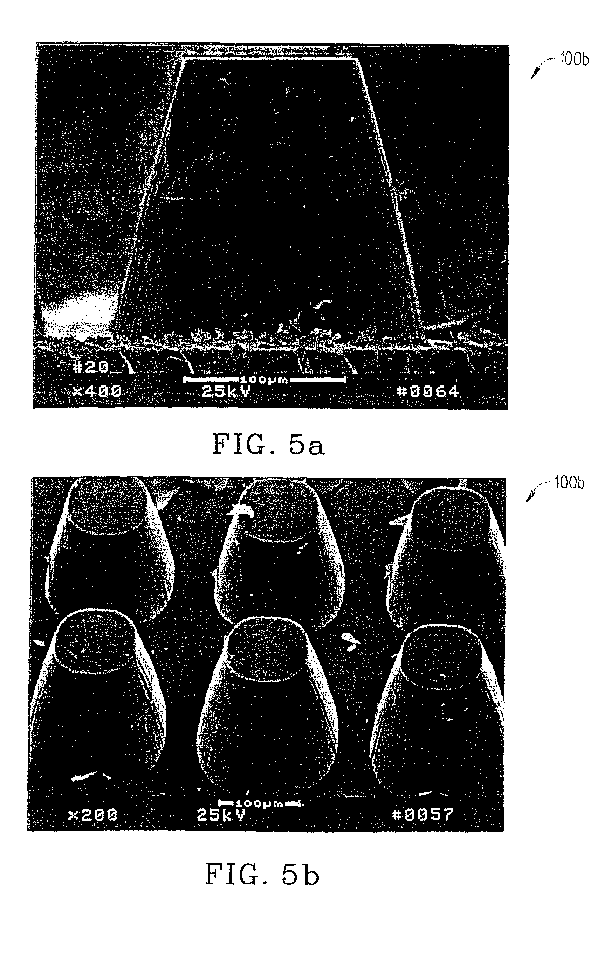

Referring to FIGURES 5a-5b, there are illustrated different perspective views of pins in a pin plate 100b that was made using Surface Technology System's (STS's) multiplex reactive ion etching process with inductively coupled plasma. STS's multiplex reactive ion etching process used to manufacture the illustrated pin plates 110b had the following properties:
- Etch plasma = C₄F₈:H:He (10:8:174 sccm).
- 4" silica wafers were etched.
- Selectivity SiO₂:SU-8 photoresist material = 1.5:2
- Etch rate = approximately 9µm/hr (power dependent).

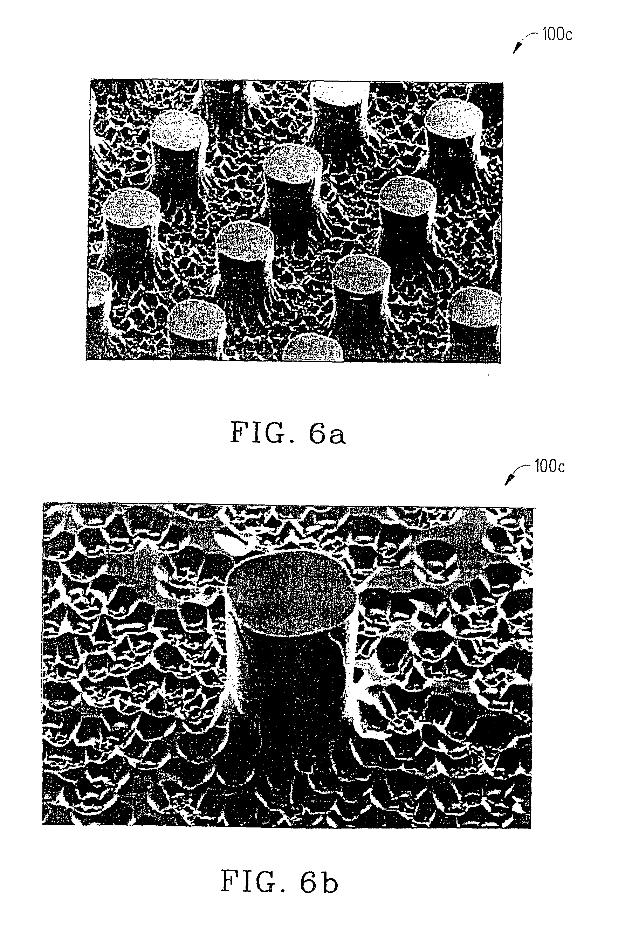

Referring to FIGURES 6a-6b, there are illustrated different perspective views of pins in a pin plate 100c that was made using IBM's reactive ion etching process without inductively coupled plasma. IBM's reactive ion etching process used to manufacture the illustrated pin plates 110c had the following properties:
- Etch plasma = CHF₃:He (6.3:0.75 sccm).
- Silica wafers of different sizes.
- Etch rate = 1.5µm/hr (power dependent).

Referring to FIGURE 7, there is illustrated a perspective view of pins in a pin plate 100d that was made using Nextral's NE500 reactive ion etching process without inductively coupled plasma. Nextral's NE500 reactive ion etching process used to manufacture the illustrated pin plates 110d had the following properties:
- Etch plasma = 100% CHF₃.
- Silica wafers of different sizes.
- Etch rate = 3µm/hr (power dependent).

From the foregoing, it can be readily appreciated by those skilled in the art that the pin plate 100 of the present invention can have certain characteristics and properties which include the following: transparency so that transmission is greater than 80% in the visible light spectrum; flexibility in the pin height and pitch in the range of 50 to 500µm in height and 40µm to 500µm in pitch; a high aspect ratio (height/width of pin) of up to 20; good flatness on the tops of the pins; good surface quality on the pins with low roughness less than 0.2µm; good size control of the pins during manufacture, i.e. the pin height, width and pitch are each within 1µm of the desired value; and good contact wet/dewet on the appropriate outer surfaces on the pins where the dewet surfaces have an advancing contact angle greater than 90° and a receding contact angle less than 20°.

Although several embodiments of the present invention have been illustrated in the accompanying Drawings and described in the foregoing Detailed Description, it should be understood that the invention is not limited to the embodiments disclosed, but is capable of numerous rearrangements, modifications and substitutions without departing from the spirit of the invention as set forth and defined by the following claims.

## Claims

1. A pin plate, comprising:
a substrate; and
a plurality of pins, each pin was formed by using a reactive ion etching process to etch away a predetermined amount of a top surface from said substrate that was not covered by a substantially thick layer of photoresist material.

2. The pin plate of Claim 1, wherein each pin further includes a top surface coated with a wetting material and a side surface coated with a non-wetting material.

3. The pin plate of Claim 1, wherein said substrate is made from a polished silica wafer.

4. The pin plate of Claim 1, wherein said photoresist material is a negative-tone photoresist material that is approximately 200µm thick.

5. The pin plate of Claim 1, wherein said reactive ion etching process includes the use of inductively coupled plasma.

6. The pin plate of Claim 1, wherein said reactive ion etching process does not include the use of inductively coupled plasma.

7. A method for making a pin plate, said method comprising the steps of:
providing a transparent substrate;
coating a top surface of the transparent substrate with a substantially thick layer of photoresist material;
removing selected areas of the photoresist material from the transparent substrate;
using a reactive ion etching process to form a plurality of pins in the transparent substrate by etching away a predetermined amount of the top surface from the transparent substrate that is not covered by the photoresist material; and
removing the remaining photoresist material from the transparent substrate which resembles the pin plate.

8. The method of Claim 7, further comprising the step of coating a top surface of each pin with a wetting material.

9. The method of Claim 7, further comprising the step of buffing a top surface of each pin to make the top surface wetting to a substance that is to be printed.

10. The method of Claim 7, further comprising the step of coating a side surface of each pin with a non-wetting material.

11. The method of Claim 7, wherein said transparent substrate is made from a polished silica wafer.

12. The method of Claim 7, wherein said photoresist material is a negative-tone photoresist material that is approximately 200µm thick.

13. The method of Claim 7, wherein said reactive ion etching process includes the use of inductively coupled plasma.

14. The method of Claim 7, wherein said reactive ion etching process does not include the use of inductively coupled plasma.

15. A method for making a printing plate, said method comprising the steps of:
providing a silica wafer;
coating a top surface of the silica wafer with a substantially thick layer of photoresist material;
exposing selected areas of the photoresist material to an ultraviolet light;
developing away unexposed areas of the photoresist material from the silica wafer;
using a reactive ion etching process to form a plurality of pins in the silica wafer by etching away a predetermined amount of the top surface from the silica wafer that is not covered by the exposed photoresist material; and
removing the remaining exposed photoresist material from the silica wafer which resembles the pin plate.

16. The method of Claim 15, further comprising the step of baking the silica wafer coated with the photoresist material before exposing selected areas of the photoresist material to the ultraviolet light.

17. The method of Claim 15, further comprising the step of baking the silica wafer coated with the photoresist material after exposing selected areas of the photoresist material to the ultraviolet light.

18. The method of Claim 15, further comprising the step of coating a top surface of each pin with a wetting material.

19. The method of Claim 15, further comprising the step of buffing a top surface of each pin to make the top surface wetting to a substance that is to be printed.

20. The method of Claim 15, further comprising the step of coating a side surface of each pin with a non-wetting material.

21. The method of Claim 15, wherein said photoresist material is a negative-tone photoresist material that is approximately 200µm thick.

22. The method of Claim 15, wherein each pin has a height of approximately 150µm and a diameter of approximately 100µm.

23. The method of Claim 15, wherein said reactive ion etching process includes the use of inductively coupled plasma.

24. The method of Claim 15, wherein said reactive ion etching process does not include the use of inductively coupled plasma.

25. The method of Claim 15, wherein said reactive ion etching process uses a fluorocarbon etchant to etch away the predetermined amount of the top surface from the silica wafer that is not covered by the exposed photoresist material.

26. The method of Claim 15, wherein said pin plate is used to print a high density array of biological inks.

27. The method of Claim 15, wherein said pin plate is used to print a high density array of materials used for genomic research.

28. The method of Claim 15, wherein said pin plate is used to print a high density array of materials used for drug screening.
